# EUROPÄISCHE PATENTANMELDUNG

(11) **EP 0 564 951 A1**
(43) Veröffentlichungstag der Anmeldung: **13.10.1993**
(21) Anmeldenummer: 93105171.8
(22) Anmeldetag: 29.03.1993
(51) Int. Cl.: H03K 17/95, H03K 17/90

(54) **Mikroschalter mit Hall-Sensoren**

(30) Priorität: 06.04.1992 DE 4211486
(71) Anmelder: SIEMENS AKTIENGESELLSCHAFT, D-80333 München (DE)
(72) Erfinder: Jansseune, Luc, W-8000 München 83 (DE)

(57) **Zusammenfassung**

Der Mikroschalter enthält in einem Gehäuse (1) einen integrierten Schaltkreis (2) mit mindestens zwei Hall-Sensoren und einer Auswerteschaltung sowie einen Dauermagneten (6), dessen Magnetfeld die beiden Hall-Sensoren durchsetzt. Über eine ferromagnetische Justierplatte (12) wird das Magnetfeld unsymmetrisch über einem der Hall-Sensoren verzerrt. Diese Magnetfelddifferenz wird als Ruhezustand des Schalters ausgewertet. Durch Annäherung eines ferromagnetischen Auslösekörpers wird das Magnetfeld symmetrisch gemacht, was als Einschaltzustand gewertet wird.

## Beschreibung

Die Erfindung betrifft einen Mikroschalter mit einem integrierten Schaltkreis, der mindestens Zwei Hall-Sensoren und mindestens eine Auswerteschaltung aufweist, sowie mit einem fest unterhalb der beiden Hall-Sensoren angeordneten Dauermagneten, der mit einem Pol den beiden Hall-Sensoren zugewandt ist und dessen Feldlinien die Hall-Sensoren durchsetzen, wobei das Verhältnis der magnetischen Induktion in jedem der beiden Hall-Sensoren über die Auswerteschaltung ermittelt und aus einer Änderung dieses Verhältnisses bei Annäherung eines ferromagnetischen Auslösekörpers ein Schaltsignal abgeleitet wird.

Derartige Näherungsschalter mit Hall-Sensoren sind bekannt. Sie werden beispielsweise dazu verwendet, die Annäherung bzw. die Vorbeibewegung eines ferromagnetischen Teiles zu erfassen. Bisher ist es üblich, einen Ruhezustand des Schaltkreises bei Gleichheit der magnetischen Induktion in beiden Hall-Sensoren zu definieren. Dazu muß also ein Abgleich auf Nulldifferenz vorgenommen werden, da einerseits das Magnetfeld eines Dauermagneten nicht über die gesamte Polfläche ganz gleichmäßig ist und andererseits auch die Hall-Sensoren selbst von der Fertigung her nicht immer vollständig identisch sind. Aus der US-A-4,859,941 ist es beispielsweise bekannt, mittels einer ferromagnetischen Polplatte das Feld eines Dauermagneten für diesen Zweck gleichmäßiger zu gestalten. Ferner sind aus der US-A-5,045,920 weitere Maßnahmen bekannt, um Unsymmetrien eines derartigen Näherungsschalters möglichst zu kompensieren.

Ist ein Schaltkreis mit zwei Hall-Sensoren auf Nulldifferenz abgeglichen, so entsteht bei Annäherung eines ferromagnetischen Auslösekörpers an einen der beiden Hall-Sensoren zunächst ein Differenzsignal, welches zum Schalten ausgewertet werden kann. Wird jedoch der Auslösekörper weiter über den IG bewegt, so daß er auch das Magnetfeld in dem zweiten Hall-Sensor beeinflußt, so verschwindet bei mittiger Anordnung des Auslösekörpers über beiden Sensoren die Differenz wieder. Für Anwendungsfälle, bei denen die Vorbeibewegung beispielsweise der Zähne eines Zahnrades ausgewertet wird, ist dieser Effekt durchaus erwünscht. Will man jedoch einen Schalter mit lediglich zwei eindeutig voneinander unterscheidbaren Schaltzuständen schaffen, so ist eine derartige Aufhebung der Induktionsdifferenz durch eine Mittenstellung des Auslösekörpers unerwünscht. Es muß also in diesem Fall durch eine zusätzliche Maßnahme, etwa durch einen mechanischen Anschlag, die mittige Position des Auslösekörpers gegenüber den beiden Hall-Sensoren verhindert werden. Da nun der Auslösekörper häufig nicht eigentlich Teil des Mikroschalters ist, sondern beispielsweise ein verhältnismäßig großer ferromagnetischer Gegenstand, wie die Tür eines Kraftfahrzeuges, deren Stellung festgestellt werden soll, kann dieses Problem in der Geometrie des Mikroschalters unter Umständen nur durch eine unerwünschte Vergrößerung des Schalters gelöst werden.

Ziel der vorliegenden Erfindung ist es, einen Mikroschalter der eingangs genannten Art zu schaffen, der mit einfachem Aufbau und kleinem Volumen eine klare Unterscheidung zweier Schaltzustände, also Einschalt- und Ausschaltzustand, ermöglicht.

Erfindungsgemäß wird dies dadurch erreicht, daß eine ferromagnetische Justierplatte dem Dauermagneten gegenüberliegend im Bereich eines ersten Hall-Sensors fest angeordnet ist, daß eine dadurch vorgegebene Differenz der magnetischen Induktion als Ruhezustand festgelegt ist und daß eine Reduzierung dieser Differenz bei Annäherung des ferromagnetischen Körpers an den zweiten Hall-Sensor als Einschaltzustand des Schalters ausgewertet wird.

Bei dem erfindungsgemäßen Mikroschalter wird also im Gegensatz zu bisherigen Näherungsschaltern mit Hall-Sensoren im Ruhezustand nicht auf Nulldifferenz abgeglichen, vielmehr wird mit dem Justierblech eine Differenz der magnetischen Induktion vorgegeben. Das Magnetfeld durch die beiden Hall-Sensoren ist also bereits im Ruhezustand einseitig deformiert. Durch die Annäherung des Auslösekörpers wird nun das Magnetfeld auch im Bereich des zweiten Hall-Sensors deformiert, insgesamt also das Magnetfeld durch beide Hall-Sensoren wieder symmetrisch oder asymmetrisch in der anderen Richtung gemacht. Das Verschwinden oder Umkippen der Differenz wird also in der Auswerteschaltung als Einschaltsignal gewertet. Selbst wenn nun der Auslösekörper über die Mitte auch über den ersten Hall-Sensor geschoben wird, kann das Magnetfeld insgesamt nicht wieder die ursprüngliche Form annehmen, da die magnetische Induktion im Bereich des ersten Hall-Sensors bereits durch die Justierplatte in den Maximalbereich verschoben ist.

Durch dieses Justierplatte, die verhältnismäßig dünn sein kann, wird also das Volumen des Schalters nicht wesentlich vergrößert. Die Geometrie des Gehäuses wird insgesamt sehr einfach, so daß genormte Gehäuseabmessungen eingehalten werden können. Mit der Justierplatte kann gezielt die Differenz der magnetischen Induktion an beiden Hall-Sensoren eingestellt werden, wobei zugleich alle sonstigen Toleranzen, die vom Dauermagneten oder von den Sensoren selbst herrühren, durch entsprechende Positionierung der Justierplatte mit abgeglichen werden. Die Annäherungsrichtung des Auslösekörpers ist bei dieser erfindungsgemäßen Konstruktion zudem nicht mehr einseitig festgelegt, sondern beliebig wählbar.

In vorteilhafter Ausgestaltung des erfindungsgemäßen Mikroschalters ist der integrierte Schaltkreis mit den Hall-Sensoren in einem Gehäuse befestigt, in welchem unterhalb des Schaltkreises der Dauermagnet und oberhalb des Schaltkreises die Justierplatte einsteckbar befestigt sind. Dabei kann die Justierplatte bevorzugt in einer Gehäuseführung verschiebbar angeordnet sein; nach dem Abgleich kann diese Justierplatte dann auf übliche Weise, beispielsweise mit Klebetropfen oder dergleichen, fixiert werden.

Vorzugsweise wird das Gehäuse dadurch gebildet, daß aus einer metallischen Stanzplatine gebildete Anschluß- bzw. Leiterstreifen in Kunststoff eingebettet werden, deren erste Enden mit den Anschlüssen des integrierten Schaltkreises verbunden sind und deren zweite Enden als Anschlußelemente aus dem Gehäuse vorstehen. Es ist auch möglich, den integrierten Schaltkreis bereits zuvor mit den Leiterstreifen zu verbinden und dann gemeinsam mit diesen in dem Gehäuse einzubetten.

In einer vorteilhaften Weiterbildung der Erfindung kann zur Kompensation des Temperaturgangs des magnetischen Kreises, insbesondere des integrierten Schaltkreises mit den beiden Hall-Sensoren ein Kompensationsblech vorgesehen werden. Zu diesem Zweck wird ein Material mit einem positiven Temperaturkoeffizienten des magnetischen Widerstandes in den durch den zweiten Hall-Sensor gehenden Magnetflußkreis eingebracht. Auf diese Weise läßt sich die als Schaltschwelle dienende Flußdifferenz in einem vorgegebenen Temperaturbereich weitgehend konstant halten. Da das Kompensationsblech aber generell die ursprünglich eingestellte Magnetfelddifferenz verringert, muß diese durch eine entsprechende Verschiebung des Justierbleches wieder auf den ursprünglich vorgesehenen Wert gebracht werden.

Beim Einsatz des Mikroschalters als Annäherungsdetektor ist, wie bereits erwähnt, der Auslösekörper häufig nicht Teil des Schalters selbst. Es ist aber auch möglich, mit dem Gehäuse einen Auslösekörper zu verbinden, beispielsweise eine schwenkbar gelagerte ferromagnetische Feder.

In weiterer Ausgestaltung kann in dem Gehäuse auch ein zusätzliches Bauelement, etwa ein Widerstand oder eine Diode, als Überbrückungsglied zwischen zwei Leiterstreifen eingebettet sein. In den Unteransprüchen sind weitere Ausgestaltungen angegeben.

Die Erfindung wird nachfolgend an Ausführungsbeispielen anhand der Zeichnung näher erläutert. Es zeigen
Figur 1 bis 3 einen erfindungsgemaß gestalteten Mikroschalter in drei Ansichten,
Figur 4 bis 8 eine schematische Darstellung der magnetischen Induktion an den beiden Hall-Sensoren bei verschiedenen Stellungen eines Auslösekörpers mit und ohne Justierplatte,
Figur 9, 10 und 11 einen in verschiedenen Details abgewandelten Mikroschalter in drei Ansichten,
Figur 12, 13 und 14 einen jeweils nur im Anschlußbereich des Gehäuses dargestellten Mikroschalter mit Schneidklemmanschlüssen zur Kontaktierung eines Bandkabels, ebenfalls in drei Ansichten,
Figur 15, 16 und 17 eine weitere Ausführungsform eines Mikroschalters mit einem abgewandelten Gehäuseaufbau sowie einem Kompensationsblech und
Figur 18 ein Ersatzschaltbild für den magnetischen Kreis des Schalters von Figur 16 mit Temperaturkompensation.

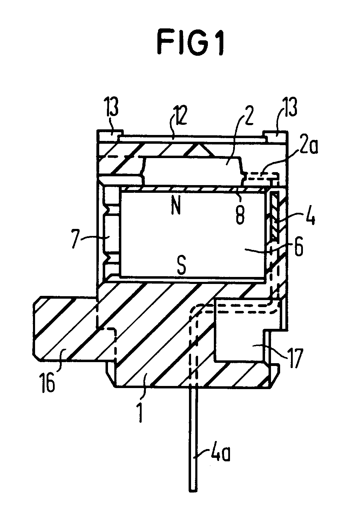

Der in den Figuren 1 bis 3 dargestellte Mikroschalter besitzt ein Gehäuse 1, in welchem ein als Hall-Differenz-Chip ausgeführter integrierter Schaltkreis (IC) 2 sowie drei Leiterstreifen 3, 4 und 5 eingebettet sind. Unterhalb des IC 2 ist ein Dauermagnet 6 in eine seitlich offene Kammer 7 eingesteckt, so daß ein Pol (N) dem integrierten Schaltkreis 2 zugewandt ist. Auf dem dem IC zugewandten Dauermagnetpol N ist ein Polblech 8 aus Nickel-Eisen-Material angeordnet, um Ungleichförmigkeiten des Magnetfeldes auszugleichen. Der integrierte Schaltkreis ist im gezeigten Beispiel mit den Leiterstreifen in den Gehäusekunststoff eingespritzt. Er könnte aber ebenso wie der Dauermagnet auch eingesteckt sein. Auch die Leiterstreifen als Anschlußelemente könnten durch Stecken befestigt sein. Wie aus Figur 1 erkennbar ist, sind die Leiterstreifen 3, 4 und 5 innerhalb des Gehäuses abgekröpft, um den Raum für den Dauermagneten 6 frei zu lassen. Jeder der Leiterstreifen 3, 4 und 5 ist mit einem Anschlußelement 2a des integrierten Schaltkreises verbunden. Neben der hier gezeigten Dreidrahtübertragung zwischen IC und externem Anschluß ist auch ein Zweidrahtbetrieb möglich, wie dies für derartige integrierte Schaltkreise üblich ist. Integrierte Differenz-Hall-Schaltkreise sind handelsüblich, beispielsweise unter der Bezeichnung TLE492OG oder TLE492lUD von Siemens.

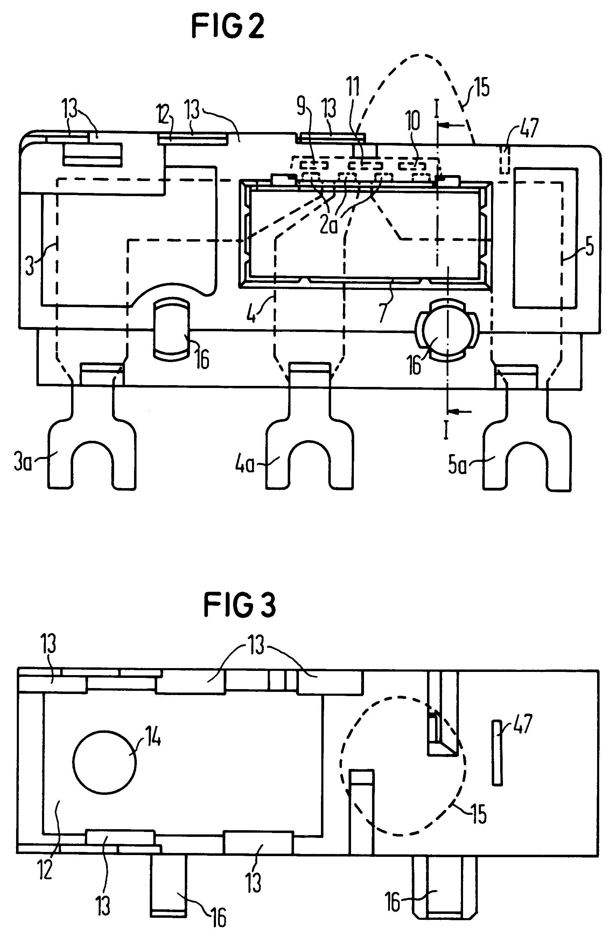

Wie in Figur 2 andeutungsweise gezeigt ist, sind in dem integrierten Schaltkreis 2 zwei Hall-Sensoren 9 und 10 sowie eine Auswerteschaltung 11 vorgesehen. Ausgewertet wird dabei in bekannter Weise eine auftretende Magnetfelddifferenz zwischen den beiden Hall-Sensoren 9 und 10. Bei dem dargestellten Mikroschalter ist im Bereich oberhalb des integrierten Schaltkreises 2 eine zusätzliche Justierplatte 12 so angeordnet, daß sie an den ersten Hall-Sensor 9 angenähert ist. Die Justierplatte 12 ist in einer Führung des Gehäuses, gebildet durch Führungsnasen 13, in Längsrichtung verschiebbar geführt. Dadurch kann sie bei der Montage mehr oder weniger an den Hall-Sensor 9 angenähert bzw. über diesen geschoben werden. Zur Erleichterung der Justierung besitzt die Justierplatte ein Griffloch 14, in welches beispielsweise mit einem Stift eingegriffen werden kann. Nach Durchführung der Justierung kann dieses Loch 14 beispielsweise mit Klebstoff ausgefüllt werden, um die Justierplatte 12 zu fixieren. Der Schalter wird so justiert, daß ein Schaltsignal von Ein auf Aus bzw. umgekehrt erzeugt wird, wenn ein ferromagnetischer Auslösekörper in den kuppelförmigen Auslösebereich 15 hineingebracht wird bzw. diesen verläßt. Dieser Auslösebereich 15 ist in Figur 2 und 3 jeweils gestrichelt angedeutet.

Bei der Herstellung des Schalters kann beispielsweise eine metallische Stanzplatine mit teilweise freigestanzten Leiterstreifen 3, 4 und 5, die noch mit einem Tragband verbunden sind, zunächst mit dem IC verbunden und dann mit Kunststoff umspritzt werden, um das Gehäuse auszuformen. Danach werden der Dauermagnet 6 und die Polplatte 7 eingesteckt. Zur Fixierung und Abdichtung des Magnetraums kann das Gehäuse mit Gießharz vergossen werden. Danach werden bei dieser Art Fertigung die Leiterstreifen 3, 4 und 5 aus dem Transportband freigeschnitten, so daß die Anschlußfahnen 3a, 4a und 5a freiliegen. Wie aus den Figuren 1 bis 3 weiter ersichtlich ist, sind bei dem gezeigten Beispiel am Gehäuse jeweils Zapfen 16 und komplementäre Löcher 17 eingeformt. Damit können mehrere Schalter aneinandergereiht und durch Stecken verbunden werden. Es können aber auch nur Löcher oder nur Zapfen vorgesehen werden.

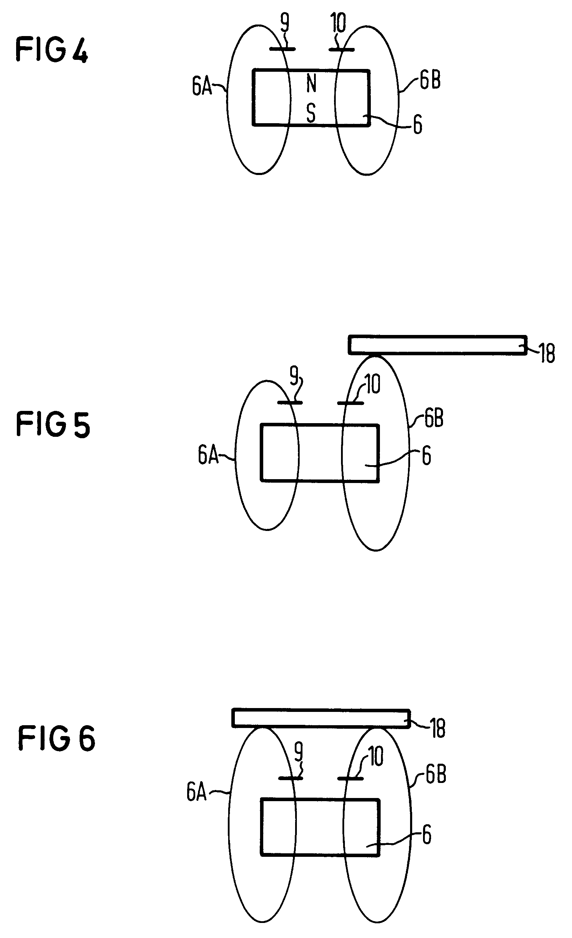

Im folgenden soll anhand der Figuren 4 bis 8 die Wirkungsweise des Schalters mit der Justierplatte 12 erläutert werden. Dabei ist jeweils das Magnetfeld des Dauermagneten 6 durch kleinere oder größere Ellipsen schematisiert dargestellt. Figur 4 zeigt schematisch die Anordnung von zwei Hall-Sensoren 9 und 10 über einem Pol des Dauermagneten 6.

Da das Feld des Dauermagneten durch keine äußeren Einflüsse deformiert ist, ist die magnetische Induktion in beiden Sensoren 9 und 10 gleich. Dies ist in Figur 4 durch zwei gleiche Ellipsen 6A und 6B angedeutet. In dem Hall-Differenz-Chip 2, der die beiden Hall-Sensoren 9 und 10 enthält, ist also keine Flußdifferenz wahrzunehmen. Für übliche Hall-Differenz-Schalter wird dieser Zustand als Ruhezustand definiert.

Wird nun bei einem derartigen Hall-Differenz-Schalter gemäß Figur 5 ein ferromagnetischer Auslösekörper 18 an den Hall-Sensor 10 angenähert, so verstärkt sich das Magnetfeld in dessen Bereich, was durch eine vergrößerte Ellipse 6B angedeutet ist. Diese Deformierung des Magnetfeldes wird in einer Auswerteschaltung als Differenzsignal wahrgenommen und in einer Änderung des Schaltzustandes ausgewertet. Wird aber nun, wie in Figur 6 gezeigt, der Auslösekörper weiter über die Hall-Sensor-Anordnung geschoben, so daß beide Sensoren 9 und 10 überdeckt sind, so wird auch das Magnetfeld über dem Sensor 9 deformiert, so daß die Differenz wieder zu Null wird. Bei einem Ein-Aus-Schalter ist eine solche Wirkung unerwünscht. Es muß deshalb durch zusätzliche Maßnahmen verhindert werden, daß der Auslösekörper beide Sensoren beeinflußt.

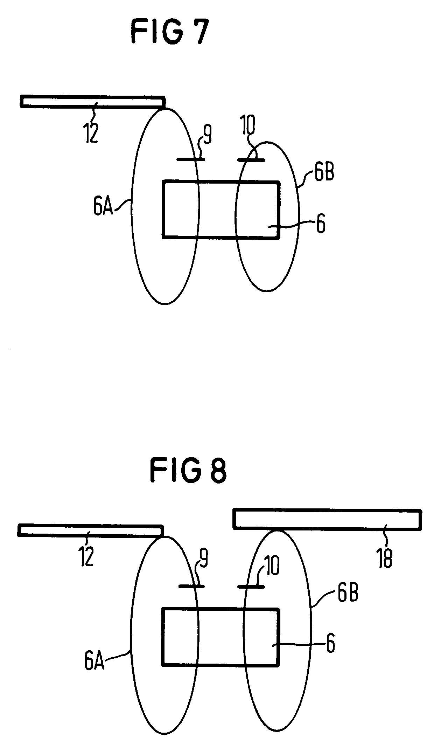

Bei der erfindungsgemäßen Anordnung wird nun gemäß der schematischen Darstellung in Figur 7 bereits im Ruhezustand eine Justierplatte 12 in den Bereich des Hall-Sensors 9 gebracht, so daß das Magnetfeld in dessen Bereich bereits im Ruhezustand deformiert wird. Durch Justieren dieser Justierplatte 12 kann somit eine ganz bestimmte Magnetfelddifferenz eingestellt werden, die als Ausschaltzustand des Schalters festgelegt ist. Wird nun ein ferromagnetischer Auslösekörper 18 an den Hall-Sensor 10 angenähert, so wird das Magnetfeld in dessen Bereich zusätzlich deformiert, bis die vorher eingestellte Magnetfelddifferenz verschwindet. Das Magnetfeld ist also jetzt wieder symmetrisch oder allenfalls in der entgegengesetzten Richtung unsymmetrisch, und das Signal am Ausgang der Auswerteschaltung kippt um. Der symmetrische oder umgekippte Zustand des Magnetfeldes wird als Einschaltzustand festgelegt. Wird nun der Auslösekörper 18 weiter zur Mitte des Schaltkreises oder sogar über die Justierplatte 12 geschoben, so kann sich der Zustand des Magnetfeldes nicht mehr ändern, da bereits beide Seiten durch ferromagnetische Teile deformiert sind. Der Ausgang bleibt also stabil in dem einmal erreichten Zustand.

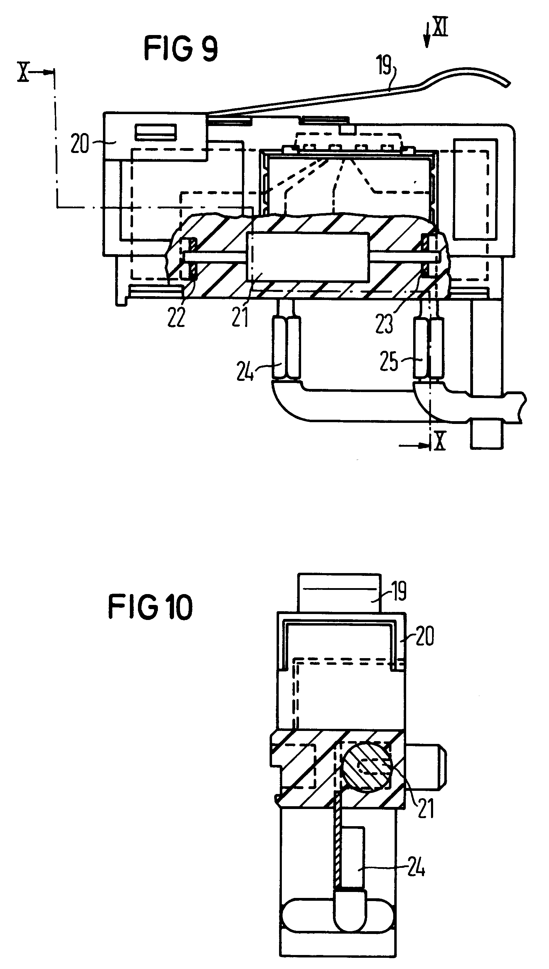

In den Figuren 9 bis 11 ist in drei Ansichten, mit teilweise aufgebrochenem Gehäuse, ein gegenüber Figur 1 verschiedentlich abgewandelter Mikroschalter gezeigt. So ist hier ein mit dem Schalter fest verbundener Auslösekörper 19 dargestellt, der in Form einer ferromagnetischen Feder über Rastarme 20 auf dem Gehäuse befestigt ist. Über die Justierplatte 12 wird dabei der Auslösebereich so eingestellt, daß im dargestellten entspannten Zustand der Feder 19 eine Magnetfelddifferenz als Ruhezustand und beim Niederdrücken der Feder 19 ein symmetrisches Magnetfeld als Einschaltzustand ausgewertet wird.

In den Figuren 9 und 10 ist als weitere Ausgestaltungsmöglichkeit gezeigt, daß in dem Gehäuse 1 ein zusätzliches Bauelement 21, beispielsweise ein Widerstand oder eine Diode, eingebettet sein kann. Dies ist beispielsweise beim Übergang von drei Anschlüssen auf zwei Anschlüsse zweckmäßig. Für den Anschluß des zusätzlichen Bauelementes 21 sind beispielsweise an den eingebetteten Leiterstreifen abgebogene Klemmlappen 22 bzw. 23 vorgesehen.

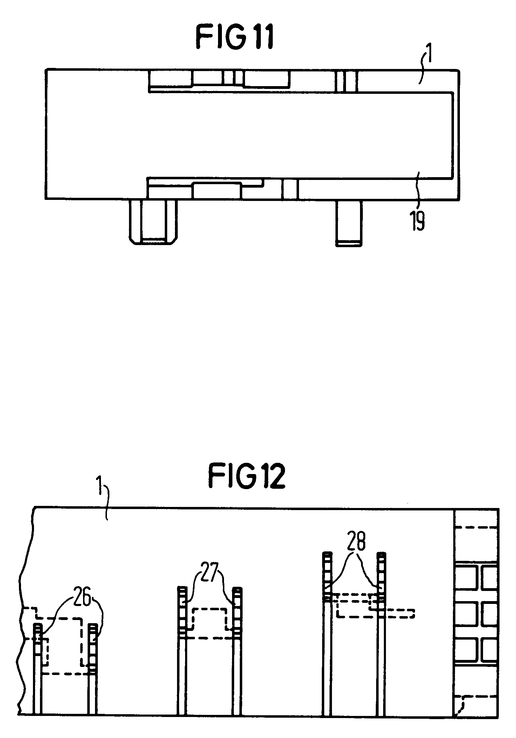

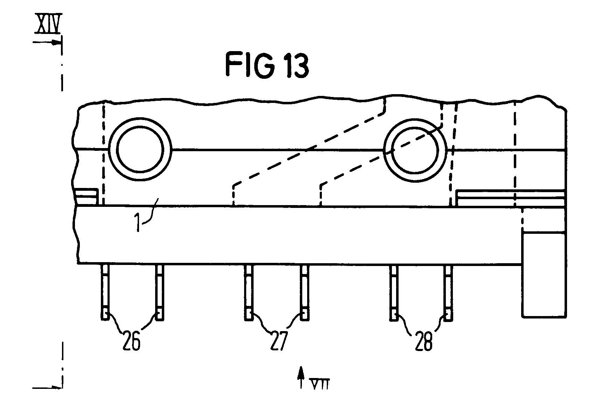

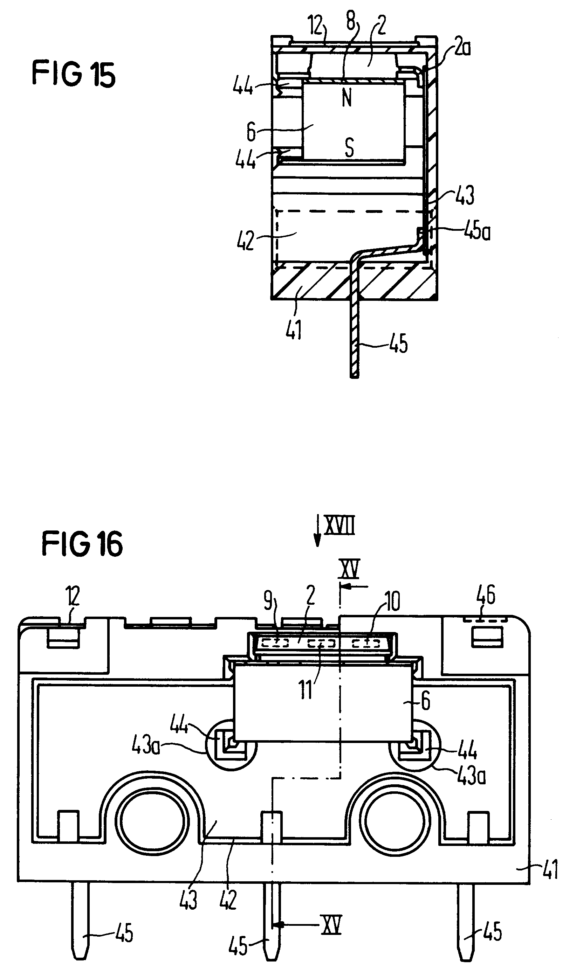

Die nach außen geführten Anschlüsse des Schalters können jede beliebige Form haben, also beispielsweise die Form von Lötösen, wie in Figur 2 gezeigt, oder etwa die Form von Crimpanschlüssen 24 und 25, wie in Figur 9 gezeigt. Aber auch alle sonstigen Anschlußarten, wie Lötstifte, Flachstecker, Rundstecker oder Vierkantstecker, kommen in Betracht. Eine besonders vorteilhafte Ausgestaltung zeigen hierzu noch Figuren 12 bis 14, wo jeweils nur der untere Gehäuseteil gezeigt ist. In diesem Fall sind jeweils paarweise vorgesehene Schneidklemmanschlüsse 26, 27 und 28 ausgebildet, die durch entsprechende unterschiedliche Abkröpfung der Leiterstreifen 29 im unteren Bereich des Gehäuses gegeneinander versetzt angeordnet sind. Diese Anschlußart ist besonders günstig für den direkten Anschluß des Schalters an ein Flachbandkabel 30. Dieses Flachbandkabel 30 stellt beispielsweise einen durchgehenden Bus dar, der verschiedene Bauelemente und elektrische Einheiten miteinander verbindet. In diesem Fall kann der Mikroschalter mit seinen Crimpanschlüssen 26, 27 und 28 jeweils direkt auf die Einzelleiter 31, 32 und 33 des Flachbandkabels 30 aufgesteckt werden, ohne daß das Kabel abisoliert oder unterbrochen werden muß. Mit einem Klemmbügel 34, der von unten auf das Schaltergehäuse 35 aufgesteckt wird, werden die Einzelleiter des Flachbandkabels in die einzelnen Klemmschlitze eingedrückt. Zu diesem Zweck besitzt der Klemmbügel 34 jeweils Druckleisten 35, die zwischen die paarweise angeordneten Schneidklemmanschlüsse 26, 27 bzw. 28 eingreifen. Der Klemmbügel ist in Figur 14 in Vorbereitungsstellung gezeigt. Nach dem Anklemmen des Flachbandkabels und der Kontaktierung mittels des Klemmbügels bzw. der Druckleiste 35 rastet der Klemmbügel mit seinen Ausnehmungen 36 an den oberen Rastnasen 37 ein und sichert so die Schneidklemmverbindungen.

In den Figuren 15 bis 17 ist eine weitere Ausführungsform eines Mikroschalters gezeigt, bei dem verschiedene Abwandlungen dargestellt sind, die voneinander unabhängig auch bei den vorherigen Ausführungsbeispielen angewendet werden können. So zeigt diese Ausführungsform ein schachtelförmiges Gehäuse 41 mit einer großen seitlichen Öffnung 42, an deren Rückwand eine dünne Leiterplatte 43, beispielsweise eine flexible Leiterplatte angeordnet ist. Der Dauermagnet 6, die Polplatte 8 und der integrierte Schaltkreis 2 werden zwischen Gehäusewänden und säulenförmigen Haltenasen 44 durch Stecken und Einklemmen befestigt. Die Leiterplatte 43 wird beispielsweise vor der Montage des Dauermagneten 6 in das Gehäuse eingebracht und dabei mit entsprechenden Ausnehmungen 43a über die Haltenasen 44 gesteckt. Die abgebogenen Anschlüsse 2a des integrierten Schaltkreises 2 und die ebenfalls abgebogenen Anschlüsse 45a von Lötstiften 45 werden mit der Leiterplatte 43 verbunden, beispielsweise durch Reflow-Löten oder Laser-Bonden oder auf eine andere geeignete Weise. In der Gehäuseöffnung 42 ist außerdem Platz für zusätzliche Bauelemente, wie einen weiteren IC, für Widerstände, Kondensatoren usw. , die mit der Leiterplatte verbunden werden.

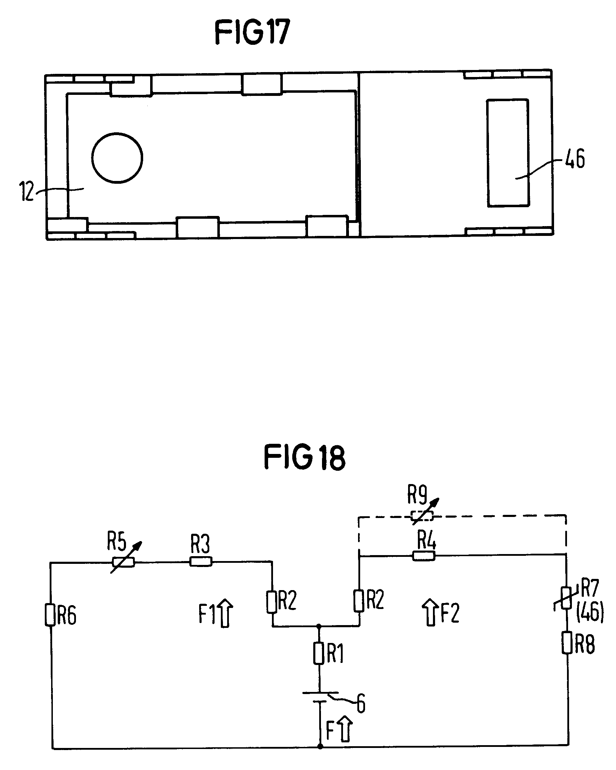

In den Figuren 16 und 17 ist außerdem ein Kompensationsblech 46 gezeigt, welches im Bereich des durch den Hall-Sensor 10 gehenden Zweiges des Magnetflusses angeordnet ist. Dieses Kompensationsblech 46 besteht aus einem Material mit einem positiven Temperaturkoeffizienten des magnetischen Widerstandes; das bedeutet, daß der magnetische Widerstand mit steigender Temperatur ebenfalls ansteigt. Beispielsweise kommt die unter dem Warenzeichen "Thermoflux" bekannte Fe-Ni-Legierung in Betracht. Auf diese Weise läßt sich die temperaturbedingte Änderung der Schaltkuppel 15 (siehe Figur 2) reduzieren. Da die Schaltdifferenz durch das Kompensationsblech insgesamt verringert wird, muß diese durch eine entsprechende Verschiebung der Justierplatte 12 am ersten Hall-Sensor 9 auf die vorgesehene Größe gebracht werden.

Figur 18 zeigt an einem Ersatzschaltbild die Wirkung des Kompensationsbleches 46. Dabei sind die magnetischen Widerstände der einzelnen Magnetkreisteile aufgezeichnet. Es bedeutet R1 den Widerstand des Polbleches am Dauermagneten 6, R2 den jeweiligen magnetischen Widerstand im integrierten Schaltkreis, R3 und R4 jeweils den magnetischen Widerstand von Luft, R5 den magnetischen Widerstand des Justierblechs 12, R6 und R8 wiederum die zwischenliegenden Luftstrecken. R7 ist der magnetische Widerstand des Kompensationsbleches 46, während R9 den Auslösekörper, beispielsweise 18 oder 19, darstellt. Durch Anordnung des Kompensationswiderstandes R7 im Kreis des Magnetflußzweiges F2 wird dessen Differenz gegenüber dem Magnetflußzweig F1 unempfindlicher gegen Temperaturänderungen.

Anstelle des waagerechten Kompensationsbleches 46 kann auch ein senkrecht angeordnetes Kompensationsblech 47 vorgesehen werden, wie in Figur 2 bzw. 3 angedeutet.

## Patentansprüche

1. Mikroschalter mit einem integrierten Schaltkreis (2), der mindestens zwei Hall-Sensoren (9, 10) und mindestens eine Auswerteschaltung (11) aufweist, sowie mit einem fest unterhalb der beiden Hall-Sensoren (9, 10) angeordneten Dauermagneten (6), der mit einem Pol den beiden Hall-Sensoren zugewandt ist und dessen Feldlinien die Hall-Sensoren durchsetzen, wobei das Verhältnis der magnetischen Induktion in jedem der beiden Hall-Sensoren über die Auswerteschaltung (11) ermittelt und aus einer Änderung dieses Verhältnisses bei Annäherung eines ferromagnetischen Auslösekörpers (18; 19) ein Schaltsignal abgeleitet wird, **dadurch gekennzeichnet,** daß eine ferromagnetische Justierplatte (12) dem Dauermagneten (6) gegenüberliegend im Bereich eines ersten Hall-Sensors (9) fest angeordnet ist, daß eine dadurch vorgegebene Differenz der magnetischen Induktion als Ruhezustand festgelegt ist und daß eine Reduzierung dieser Differenz bei Annäherung des ferromagnetischen Auslösekörpers (18; 19) an den zweiten Hall-Sensor (10) als Einschaltzustand des Schalters ausgewertet wird.

2. Mikroschalter nach Anspruch 1, **dadurch gekennzeichnet,** daß der integrierte Schaltkreis (2) in einem Gehäuse (1) befestigt ist, in welchem unterhalb des integrierten Schaltkreises der Dauermagnet (6) und/oder oberhalb des integrierten Schaltkreises die Justierplatte (12) einsteckbar befestigt sind.

3. Mikroschalter nach Anspruch 2, **dadurch gekennzeichnet,** daß die Justierplatte (12) in einer Gehäuseführung (13) verschiebbar angeordnet und nachträglich fixierbar ist.

4. Mikroschalter nach Anspruch 2 oder 3, **dadurch** **gekennzeichnet,** daß in dem Gehäuse (1) aus einer gemeinsamen metallischen Stanzplatine gewonnene Leiterstreifen (3, 4, 5) eingebettet sind, deren erste Enden mit den Anschlüssen des integrierten Schaltkreises (2) verbunden sind und deren zweite Enden als Anschlußelemente (3a, 4a, 5a) aus dem Gehäuse (1) vorstehen.

5. Mikroschalter nach einem der Ansprüche 2 bis 4, **dadurch gekennzeichnet,** daß der integrierte Schaltkreis (2) zusammen mit den Leiterstreifen (3, 4, 5) in dem Gehäuse (1) eingebettet ist.

6. Mikroschalter nach einem der Ansprüche 1 bis 5, **dadurch gekennzeichnet,** daß auf dem Gehäuse (1) eine ferromagnetische Feder (19) als Auslösekörper schwenkbar angeordnet ist.

7. Mikroschalter nach einem der Ansprüche 1 bis 6, **dadurch gekennzeichnet,** daß in dem Gehäuse (1) ein weiteres, mit mindestens zwei Leiterstreifen verbundenes Bauelement (21) eingebettet ist.

8. Mikroschalter nach einem der Ansprüche 1 bis 7, **dadurch gekennzeichnet,** daß an den Leiterstreifen jeweils gegeneinander versetzt angeordnete Schneidklemmanschlüsse (26, 27, 28) ausgebildet sind.

9. Mikroschalter nach einem der Ansprüche 1 bis 3, **dadurch gekennzeichnet,** daß in dem schachtelförmigen Gehäuse (41) eine Leiterplatte (43) angeordnet ist, an der sowohl Anschlüsse des integrierten Schaltkreises (2) als externe Anschlußelemente (45) kontaktiert sind.

10. Mikroschalter nach Anspruch 9, **dadurch gekennzeichnet,** daß in dem Gehäuse (41) Raum für zusätzlich an der Leiterplatte angeschlossene Bauelemente vorgesehen ist.

11. Mikroschalter nach einem der Ansprüche 1 bis 10, **dadurch gekennzeichnet,** daß mit dem Dauermagneten (6) eine auf dem dem integrierten Schaltkreis (2) zugewandten Pol aufliegende ferromagnetische Polplatte (8) in eine Gehäusekammer (7) eingesteckt ist.

12. Mikroschalter nach einem der Ansprüche 1 bis 11, **dadurch gekennzeichnet,** daß in dem durch den zweiten Hall-Sensor (10) gehenden Magnetflußkreis (F2) ein Kompensationsblech (46) mit einem positiven Temperaturkoeffizienten des magnetischen Widerstandes angeordnet ist.
